# EUROPEAN PATENT APPLICATION

(11) **EP 4 845 374 A1**
(43) Date of publication of application: **25.11.2026**
(21) Application number: 25201333.9
(22) Date of filing: 10.09.2025
(51) Int. Cl.: H10P 14/20, H10P 14/24

(54) **SIMULTANEOUS GROWTH OF NANODOTS AND SUPERLATTICES VIA STRAIN ENGINEERING**

(30) Priority: 22.05.2025 EP 25178134
(71) Applicant: IHP GmbH - Leibniz Institute for High Performance Microelectronics/ Leibniz-Institut für innovative Mikroelektronik, 15236 Frankfurt (Oder) (DE)
(72) Inventor: Wen, Wei-Chen, 15236 Frankfurt (Oder) (DE); Yamamoto, Yuji, 15236 Frankfurt (Oder) (DE); Makihara, Katsunori, 15236 Frankfurt (Oder) (DE); Mai, Andreas, 15236 Frankfurt (Oder) (DE)
(74) Representative: Eisenführ Speiser

(57) **Abstract**

A semiconductor device (100) comprises a patterned epiwafer (50) with a first laterally defined surface area (1) made of SiGe and, a second laterally defined surface area (2) made of Si or SiGe. The semiconductor device further comprises a planar superlattice (10) and a nanodot-superlattice (20) which are made of a periodic layer sequence of a spacer-layer (4) made of Si or SiGe or C-doped Si and a confinement-layer (5) made of Ge or SiGe. Due to a selected Ge fraction in the first surface area (1) and a first local strain amount in the confinement-layer (5), the confinement-layer (5) of the planar superlattice (10) is planar, and due to a selected Ge fraction in the second surface area (2) and a second local strain amount in the confinement-layer (5), the confinement-layer (5) of the nanodot-superlattice (20) comprises Ge or SiGe nanodots.

## Description

### FIELD OF THE INVENTION

The present invention relates to the field of semiconductor manufacturing and nanostructure fabrication, particularly to methods for producing three-dimensionally ordered epitaxial nanodot arrays. The invention addresses advancements in strain-engineered heterostructures for applications in quantum computing and optoelectronic devices, which could enable precise control over nanodot alignment in vertical and lateral dimensions.

### BACKGROUND

The formation of three-dimensional (3D) ordered SiGe nanodots via Stranski-Krastanov growth mechanisms has been studied for its potential in carrier confinement applications. As demonstrated in Y. Yamamoto, et al., Nanotechnology 28 (48), (2017) 485303, and Y. Yamamoto et al., Semicond. Sei. Tech 33 (11), (2018) 114014, the controlled vertical alignment of SiGe nanodots through superlattice deposition on Si (001) substrates was investigated, utilizing adjustments in precursor gases (e.g., SiH₄, SiH₂Cl₂) and Si spacer growth temperatures. However, existing techniques primarily focused on transitioning between nanodot formation (nanodot superlattice) and planar superlattice by modulating Ge concentration of the SiGe superlative layer or lowering Si growth temperatures to suppress surface migration. In other words, according to the prior art, the formation of nanodots was promoted or inhibited by adjusting the process conditions or the concentration of the SiGe layer in the superlattice. Consequently, in order to form an area without nanodots, either the process conditions, such as the gas composition or temperature, or the Ge concentration in the superlattice layers must be adjusted. Therefore, the formation of an area with nanodots and an area without nanodots was only possible by changing these parameters.

### SUMMARY OF THE INVENTION

The present invention aims to overcome these limitations, introducing a novel semiconductor device and a process for manufacturing such semiconductor device which enables the simultaneous formation of planar superlattice and nanodot superlattice.

The invention thus relates to semiconductor devices and a methods of manufacturing a semiconductor device as described hereafter and further as defined in the independent claims and dependent claims.

A semiconductor structure according to the invention comprises an epiwafer comprising a substrate with, at least one first laterally defined surface area made of SiGe with a first Ge fraction and, at least one second laterally defined surface area made of Si or SiGe with a second Ge fraction smaller than the first Ge fraction.

The semiconductor structure further comprises at least one first sector comprising a planar superlattice deposited on the first surface area and at least one second sector comprising a nanodot-superlattice deposited on the second surface area. The planar superlattice and the nanodot-superlattice are made of a differentially deposited periodic layer sequence of a spacer-layer made of Si or SiGe with a third Ge fraction or carbon (C) doped Si with a C fraction and a confinement-layer made of Ge or SiGe with a fourth Ge fraction higher than the third Ge fraction.

In the semiconductor structure, due to a selected first value of the first Ge fraction in the first surface area and a first local strain amount in the confinement-layer the confinement-layer of the planar superlattice is planar, that is, without any nanodot formation. Furthermore, due to a selected second value of the second Ge fraction in the second surface area and a second local strain amount in the confinement-layer the confinement-layer of the nanodot-superlattice comprises Ge or SiGe nanodots.

The semiconductor device of the present invention overcomes the limitations and challenges of the prior art described above and is based on the observation that the planar superlattice and the nanodot superlattice can be formed without changing growth conditions, such as temperature setting, precursor gas setting, gas flow setting, etc. for the deposition of the planar superlattice and the nanodot superlattice. The distinct structure of the nanodot and planar superlattices is rather achieved by proper strain engineering, in particular by providing differing Ge fractions in the underlying surface areas of the epiwafer. Providing different Ge fractions in the first and second surface areas achieves a spatial modulation of the strain balance during the simultaneous growth of the confinement-layers and the spacer layers for the planar superlattice and in the nanodot superlattice.

The invention is based on the recognition that by selecting a suitable first Ge fraction in the first surface area underlying the planar superlattice, compressive strain in the Ge or SiGe crystal lattice of the confinement-layer of the planar superlattice can be set suitably low, and a tensile strain in the spacer-layer of the planar superlattice can be set suitably high to prevent a formation of Ge or SiGe nanodots in the Ge or SiGe confinement-layer and instead trigger the growth of a planar confinement-layer in the first sector.

Due to the structure of the epiwafer in particular, thus, a processing advantage can be achieved in that the confinement-layer and/or the spacer-layer in the first and second sector can be formed simultaneously. Since the first sector and the second sector are formed simultaneously, their individual layers are deposited under identical and uniform respective process settings for their deposition process. In the semiconductor device of the present invention, planar and nanodot superlattice sectors thus comprise a respective periodic sequence of spacer-layers and confinement-layers with many identical properties, except for the characteristic of comprising only planar confinement layers in the first sector and only nanodot confinement layers in the second sector.

Embodiments of the semiconductor device according to the invention are described below. The additional features of the embodiments may be combined with each other to form further embodiments, unless they are expressly described as mutually exclusive alternatives.

It is noted that after the simultaneous growth according to the present invention, additional layers may be deposited individually on each of the superlattices according to the requirements of a particular application case.

Regarding use of terms in the context of semiconductor devices, a superlattice is a periodical layer structure, which as such is well known. In accordance with this known meaning, a superlattice is a periodically layered structure of alternating material layers (e.g. Si/SiGe) that are epitaxially deposited on a substrate. The superlattice of a semiconductor device according to the present invention can comprise any number of periods that complies with a desired application function of the semiconductor device. Non-limiting examples have 5, 10, 20, 50 or 100 periods.

The semiconductor device of the present invention comprises its differing superlattices in two different sectors: a first sector comprises the planar superlattice, and a second sector comprises a nanodot superlattice. The planar superlattice comprises alternating planar spacer-layers and planar confinement-layers. The nanodot superlattice is a periodic multilayer structure composed of alternating spacer-layers with a planar upper interface and confinement-layers, in which self-organized Ge or SiGe nanodots are formed. In particular, the nanodots form at the top surface of the confinement-layers due to strain-induced nucleation. The top surface of the confinement layer is defined as the interface oriented toward the spacer layer along the growth direction of the superlattice. A wetting layer may be present at this interface, as known.

The first and second sectors may be arranged immediately adjacent to each other in a lateral direction, or they may be separated and may then be considered separate superlattices. In the semiconductor device, the application function of the planar superlattice and the nanodot superlattice may be different. For instance, without limiting the invention to this particular example, one of the two superlattices may serve for light emission, light detection or an electronic function, and the other may serve for contacting.

The epiwafer serves as a crystalline basis for epitaxial growth and comprises a substrate and one or more levels of epilayers. Preferably, only one level of epilayers is used. Thus, the epiwafer may be formed of a substrate with epilayers which form the first and second surface areas: one set of one or more laterally defined epilayers is composed of SiGe with the first Ge fraction, forming the first surface area(s), and the other set of one or more laterally defined epilayers is composed of Si or SiGe with the second Ge fraction, forming the second surface area(s). The second Ge fraction is smaller than the first Ge fraction. The first and the second surface are thus distinguished by their material composition, resulting in differing lattice parameters to achieve the desired strain modulation.

The substrate of the epiwafer is typically made of silicon. The substrate may either provide mechanical stability by itself and in that case has a thickness of preferably more than 500°nm, or it may be provided on a carrier that provides mechanical stability. In the latter case, a substrate thickness smaller than 500 nm may be used.

The set of all epilayers forming the first and second surface areas may cover the entire substrate or alternatively only part of it. In the context of the epilayers and surface areas, "laterally defined" refers to a spatial limitation in one or more directions that are parallel to the surface of the substrate. The fact that the first and second surface areas are formed in distinct lateral regions of the same epiwafer surface, each with different material compositions (e.g., Ge fraction), enables localized structural differences in different lateral areas of the semiconductor device.

The thickness of those epilayers, which form the first surface area and the second surface area, is selected preferably in a range between 10 nm to 1000 nm, in accordance the requirements of their strain engineering function. The thickness of the epilayers forming the first surface area and the second surface area is preferably over 500 nm. The thickness of the epilayers forming the first surface area and the second surface area may be identical, but may be different in alternative embodiments.

The first Ge fraction of the first surface area may be within a range between 15 to 95 %, preferably the first Ge fraction of the first surface area is 15 %. In one embodiment, the first Ge fraction of the first surface area is 5 to 15% lower than the fourth Ge fraction of the confinement-layer.

The second Ge fraction of the second surface area may range between 0 and 70 %. The material composition of the second surface area may thus be identical with that of a silicon substrate of the epiwafer.

In one embodiment, the fourth Ge fraction of the confinement-layer of the first sector and second sector is at least 30 % larger than the second Ge fraction of the second surface area. That is, the fourth Ge fraction may be within a range between 30 to 100 %. However, it is preferred that the fourth Ge fraction is 30 %.

As mentioned, the spacer-layer is made of Si or SiGe with a third Ge fraction or C doped Si with a C fraction and the confinement-layer is made of Ge or SiGe with a fourth Ge fraction higher than the third Ge fraction. The third Ge fraction of the spacer-layer of the first sector and second sector may be 15 to 55% lower than the fourth Ge fraction of the confinement-layer. That is, the third Ge fraction may be within a range between 0 to 85 %. The third Ge fraction is more preferably 0 % (pure Si). It should be mentioned that a negative value of the third Ge fraction makes no physical sense. If the fourth Ge fraction is smaller than 55 %, the third Ge fraction is at least 0 %.

The planar substrate and the nanodot superlattice are preferably deposited directly on their respective surface areas, i.e. first surface area, second surface area. To achieve the desired strain engineering effect according to the present invention, the material composition of the superlattice layers is selected with a view to the material compositions of the first and second surface areas. However, it is also necessary to take account of their function in the superlattice, i.e. confinement layer and spacer layer. To achieve carrier confinement, the confinement layer should have a lower band gap energy than the spacer layer. In one embodiment, the third Ge fraction of the spacer-layer of the first sector and second sector is 15 to 55% lower than the fourth Ge fraction of the confinement-layer. Carbon may be used in the confinement layers and in the spacer layers to refine their electronic and structural properties as desired. In different embodiments, the C fraction of the spacer-layer of the first sector and second sector lies between 0 and 5 %.

As used herein, the layer thickness is the extension of a single layer (spacer- or confinement-layer) perpendicular to the substrate surface, and also referred to as its vertical extension. The thickness of the individual layers of the superlattices is to be measured between vertically adjacent interfaces. For example, the thickness of a given spacer layer is measured from the confinement layer-spacer layer interface at the bottom of this spacer layer to the next neighboring spacer layer- confinement layer interface at the top of this spacer layer. In the semiconductor device of the present invention, considering a given pair of differentially and simultaneously deposited layers of the planar superlattice and of the nanodot superlattice on the first or second surface areas, their thickness is substantially identical. In other words, the nanodot-superlattice of the second sector and the planar superlattice of the first sector feature identical layer thicknesses of the respective spacer-layers and confinement-layers in the same period of the superlattice. In one such embodiment, any internal interfaces between a respective pair of confinement layer and an adjacent spacer-layer in the nanodot-superlattice of the second sector and the planar superlattice of the first sector are at a respective substantially identical distance above the first surface area and second surface area of the epiwafer in a stacking direction of the superlattice. This results in the advantage that the superlattice is formed uniformly in the first and second sector and that the superlattice has a uniform surface structure.

Notably, the spacer-layer and the confinement-layer of a given period may have only substantially identical respective thicknesses in both sectors. Due to the structural difference between a nanodot confinement layer, which may feature a thin wetting layer as known in the art, and a planar confinement layer, a very minor difference in thickness may occur. This may be recognizable in a highly resolved cross-sectional view only in a superlattice of more than 10 periods because the minimal differences in layer thickness of the superlattice-layers may accumulate to a recognizable level difference only after a number of superlattice periods. That said, the thickness of the spacer-layer is preferably selected to lie in a range between 10 nm to 60 nm. Furthermore, the thickness of the confinement-layer preferably lies in a range between 1.5°nm to 15 nm.

In preferred embodiments, the Ge or SiGe nanodots of the nanodot superlattice in the second sector are mutually aligned across a stacking direction of the superlattice and in a lateral direction perpendicular to the stacking direction. In other words, considering a cross-sectional view of the nanodot superlattice, nanodots on different vertical levels of the superlattice are found at substantially identical lateral positions, i.e. there are sets of nanodots on the different vertical levels which are aligned along a respective vertical line.

A further aspect of the present invention is a method of manufacturing a semiconductor device, which comprises the steps of:
- Providing an epiwafer comprising a substrate with at least one first laterally defined surface area made of SiGe with a first Ge fraction and at least one second laterally defined surface area different from the first surface area and made of Si or SiGe with a second Ge fraction, wherein the second Ge fraction is smaller than the first Ge fraction.
- Performing a differential epitaxial deposition on the first and second surface areas, comprising depositing a planar superlattice on the first surface area and depositing a nanodot-superlattice on the second surface area, wherein the planar superlattice and the nanodot-superlattice are made of a periodic layer sequence of a spacer-layer made of Si or SiGe with a third Ge fraction or carbon (C) doped Si with a C fraction and a confinement-layer made of Ge or SiGe with a fourth Ge fraction higher than the third Ge fraction, wherein
   the first Ge fraction in the first surface area and the fourth Ge fraction in the confinement-layer are selected to achieve a first local strain amount in the confinement-layer to effect growth of the confinement-layer of the planar superlattice as a planar layer, that is, without any or without any substantial nanodot formation, and wherein
   the second Ge fraction in the second surface area and the fourth Ge fraction in the confinement-layer are further selected to achieve a second local strain amount in the confinement-layer to effect growth of the confinement-layer of the nanodot-superlattice in the form of Ge or SiGe nanodots.

An advantage of the method according to the invention is that the first and second sectors of the superlattice are formed simultaneously. This means that the semiconductor device can be produced more efficiently. The spacer-layers and confinement-layers of the different superlattice structures can be formed simultaneously and under the same process conditions. This is referred to as a differential deposition within the context of the present specification. Thus, the term "differentially deposited" describes a single-step deposition process that yields distinct layer morphologies (planar vs. nanodot) in the confinement layers of the different sectors, according to the pre-patterned surface areas with differing material composition in the epiwafer. The term thus emphasizes that the structural distinction arises not from process variations (e.g., altered deposition parameters), but from differing respective local lattice parameters, resulting in differing respective local strain conditions between the substrate regions, which affect the driving force for 3D nanodot formation. The process of differentially deposition avoids separated masked growth and structuring steps, and instead relies on substrate pre-patterning to locally tune strain fields.

By proper structuring of the epiwafer, thus, nanodot superlattices and planar superlattices can be selectively and simultaneously formed in desired locations. The process of the invention allows fabricating embodiments, in which the confinement-layer of the first and second sectors are laterally connected. SiGe nanodot superlattices can for instance be used as active device areas (light emission, light detection, electronic functions, etc.) and SiGe / Si planar superlattices can for instance be used as contact areas for the nanodot superlattices. This enables the selective application of operating voltage to selected individual nanodot confinement-layers via the corresponding planar confinement-layer.

As a consequence of the process of the invention, the material composition (e.g. Si or Ge concentration) does not differ in given differentially deposited layers, e.g. in a certain spacer-layer or in a certain confinement-layer, between the first and the second sector.

The Ge concentration in the first surface area is selected to generate a first local strain in the confinement-layers of the first sector, which ensures that the confinement-layers have a planar morphology. The term planar refers to a morphologically flat, continuous layer without lateral structural elevations or depressions. There is no formation of nanodots or three-dimensional islands in this layer. The interfaces remain i.e. smooth and homogeneous over the entire extent of the layer. The planar superlattice arises under local strain conditions that suppress island formation or strain-induced self-assembly, resulting in a planar morphology with uniform superlattice thickness and epitaxial continuity. The term local strain refers to concept of the present invention that the strain is different in the first and second sectors. Specifically, spatially limited to the extension of the first sector, the strain of confinement-layers of the first sector is determined by the choice of the first Ge-fraction in the first surface area of the epiwafer and the fourth Ge-fraction in the confinement-layer. It is noted that a minor influence on the strain amount may arise from the third Ge-fraction or a C-fraction in the spacer-layer.

In contrast, due to a suitable selection of the second Ge-fraction in the second surface area and of the fourth Ge-fraction in the confinement-layer, the strain in the confinement-layers of the second sector generates a second local strain in the confinement-layers of the second sector, which triggers the formation of nanodots in the confinement-layers. It is noted, that the strain in the confinement layers contains a minor contribution from the third Ge fraction in the composition of the spacer layer, and/or from a C-fraction in the spacer-layer, if present. The self-organized growth of Ge or SiGe nanodots is due to the spontaneous formation of nanoscale Ge islands or SiGe islands in the confinement layers driven by strain relaxation mechanisms during epitaxial deposition.

The elastic strain, herein described in short as strain (lattice distortion) can be detected by µ-Raman spectroscopy (shift of characteristic phonon peaks) and Nano Beam Diffraction/NBD (precise measurement of diffraction patterns to determine local lattice parameters). TEM enables the direct mapping of strain fields by analyzing moiré patterns or dislocation networks, whereby these methods or a combination thereof enables a reversible reconstruction of the strain distribution.

Embodiments of the method of manufacturing a semiconductor structure according to the invention are described below. The additional features of the embodiments may be combined with each other to form further embodiments, unless they are expressly described as mutually exclusive alternatives.

With regard to selecting the Ge fractions in the design phase of the semiconductor device, a value for the fourth Ge fraction or second Ge fraction are suitably determined first, as the other concentrations can be deduced therefrom. In particular, the Ge fraction of the first surface area is suitably selected depending on the selected Ge fraction of the confinement-layer to form the corresponding desired strain. This simplifies the design process by taking in consideration only physically meaningful ranges.

The following table 1 gives an overview Ge concentrations in the different surface areas and superlattice sectors and respective nominal thicknesses found to be suitable combinations by the inventions, covering a wide range of possible parameter combinations, each of which is to be considered an embodiment of the present invention. In the table, the Ge concentration of the confinement-layer is denoted as Y. The Ge concentration of the spacer-layer is denoted as Z. The Ge concentration of the substrate in the second surface area is denoted as X. The Ge concentration of the substrate in the first surface area is denoted as W. The nominal thicknesses of the layers is selected also in dependence on the combination of X and Y, as well as the strain balance between the superlattice and the substrate.

**Table 1**

| Y ≥ (X+30%) | Ge concentration | | Nominal thickness |
|---|---|---|---|
| | second sector / second surface area | first sector / first surface area | |
| confinement-layer (Y) | Y = 30 % to 100 % | | 1.5 to 15 nm |
| spacer-layer (Z) | Z = Y - (15 % to 55 %) | | 10 to 60 nm |
| Substrate (X / W) | X = 0 % to 70 % | W = Y - (15 % to 5 %) | - |

In one embodiment, the method comprises forming Ge or SiGe nanodots using the Stranski-Krastanov growth mechanism known per se. In this growth mode, which is known per se, nanodots are formed at the top surface of the confinement-layer as a result of a mechanical stress state generated by the lattice mismatch (strain). The top surface of the confinement layer is defined as the interface oriented toward the spacer layer along the growth direction of the superlattice. This strain destabilizes planar growth and promotes the Stranski-Krastanov growth mode, resulting in the formation of nanodots. By properly engineering the local strain distribution of the spacer-layer of superlattice and the surface morphology of the spacer-layer, a vertical alignment of the nanodots can be achieved. The Ge or SiGe nanodots of the second sector may even be arranged in such a way that they are aligned both vertically along the stacking direction of the superlattice and horizontally in a lateral direction parallel to the substrate surface and perpendicular to the stacking direction. This double alignment leads to a regular arrangement of the nanodots in both the vertical and lateral directions, forming regularly arranged arrays of nanodots without the need for lithographic patterning. Such alignment can be achieved by suitably selecting the precursor gas and the growth temperature. The driving forces of the nanodot vertical alignment are strain energy reduction and surface energy reduction. In particular, by selecting the precursor gas (e.g. SiH₄ and SiH₂Cl₂) and the growth temperature of the spacer-layer, 3D aligned nanodot formation as well as a desired form of alignment of the nanodots (dot-on-dot/staggered) is realized. The periodically ordered alignment can be realized not only in the vertical direction but also in the lateral direction along <100>, due to the monotonic decrease in strain toward this direction.

The differential deposition comprises simultaneously forming the nanodot-superlattice and the planar superlattice. In particular, simultaneously forming the nanodot-superlattice and the planar superlattice may comprise using identical growth settings of a growth reactor used for performing the method, including an identical a precursor gas flow setting and an identical growth temperature setting.

In one embodiment, the method comprises
- setting a first growth temperature for depositing Ge or SiGe to form the confinement-layer of the nanodot-superlattice and the planar superlattice, and
- setting a second growth temperature for depositing Si or SiGe or C doped Si to form the spacer-layer of the nanodot-superlattice and the planar superlattice,
wherein the second growth temperature is higher than or equal than the first growth temperature.

In one embodiment, the first growth temperature is increased up to the second growth temperature after the deposition of the confinement-layer and before the deposition of the spacer-layer such that the spacer-layer is formed with the second growth temperature. This allows the formation of nanodots to be increased and their shape and size to be selected as desired.

It is noted that in any of the described embodiments, a variant including the formation of C-doped Si spacer-layers is similar to that of Si or SiGe spacer-layers. The substitutional carbon is used to further influence the lattice parameter. Carbon and germanium affect silicon's lattice parameters differently due to their atomic sizes. Carbon contracts the lattice when incorporated, leading to a reduced lattice constant. In contrast, germanium inclusion expands the silicon lattice. These changes influence strain in epitaxial layers: carbon induces compressive strain, while germanium causes tensile strain.

If the spacer-layer is made of C doped Si, the gas flow of the carbon precursor is selected to set the C fraction of the C doped Si spacer-layer to a value of at most 5°%, lower non-zero fractions being available as well. The layer thicknesses and their Ge concentrations as well as the properties of the nanodots and their formation correspond to those described in the context of embodiments in which SiGe or Si is used for the spacer-layer. In particular, if the spacer-layer is made of C doped Si, the Ge concentrations of the other layers apply as disclosed herein for the Si or SiGe spacer-layer.

Application cases of the semiconductor device include light-emitting applications, where the quantum confinement of carriers in the nanodots enhances photoluminescence efficiency, enabling use in optoelectronic devices such as infrared LEDs or lasers. Additionally or alternatively, the semiconductor device allows for discrete energy levels suitable for quantum applications, including qubit architectures, single-electron transistors, or neuro-morphic computing elements. The growth of adjacent planar-superlattice and nanodot-superlattice resulting in the lateral connection of planar confinement-layer and nanodot confinement-layer, enables the voltage control of individual nanodot confinement-layers via the planar confinement layers of the adjacent planar superlattice.

### BRIEF DESCRIPTION OF THE DRAWINGS

Further embodiments are explained below with reference to the figures. These show:
- Fig. 1A: a schematic cross-sectional view of an epiwafer with two distinct surface areas according to the invention;
- Fig. 1B: a schematic cross-sectional view of a semiconductor device comprising the epiwafer of Fig. 1 and a first superlattice layer deposited on top of the two epiwafer surface areas according to the invention;
- Fig. 1C: a schematic cross-sectional view of a semiconductor device comprising the epiwafer of Fig. 1 and superlattice layers deposited on top of the epiwafer surface area according to the invention;
- Fig. 2: a schematic cross-sectional view of a semiconductor device comprising the epiwafer of Fig. 1 and superlattice layers deposited on top of the epiwafer surface area according to the invention;
- Fig. 3A: a schematic cross-sectional view of a semiconductor device comprising the epiwafer of Fig. 1 and superlattice layers deposited on top of the two distinct epiwafer surface areas with dot-on-dot aligned nanodots formed in a superlattice sector above one of the two distinct surface areas of the epiwafer according to the invention;
- Fig. 3B: a schematic cross-sectional view as depicted in Fig. 3A, with nanodots arranged in a staggered alignment according to the invention.
- Fig. 4: a schematic representation of the process steps to manufacture a semiconductor device according to the invention;
- Fig. 5: a schematic representation of the deposition process of Si or SiGe or C-doped Si to form the superlattice layer according to an embodiment of the invention;
- Fig. 6: a schematic representation of the surface topography of the superlattice between the two sectors above the two distinct surface areas of the underlying epiwafer according to an embodiment of the invention;
- Fig. 7: a schematic cross-sectional view of a superlattice deposited to the epiwafer comprising two distinct surface areas according to an embodiment of the invention;
- Fig. 8: a schematic concept of the 3D staggered aligned Ge or SiGe semiconductor device according to an embodiment of the invention;

### DETAILED DESCRIPTION OF THE DRAWINGS

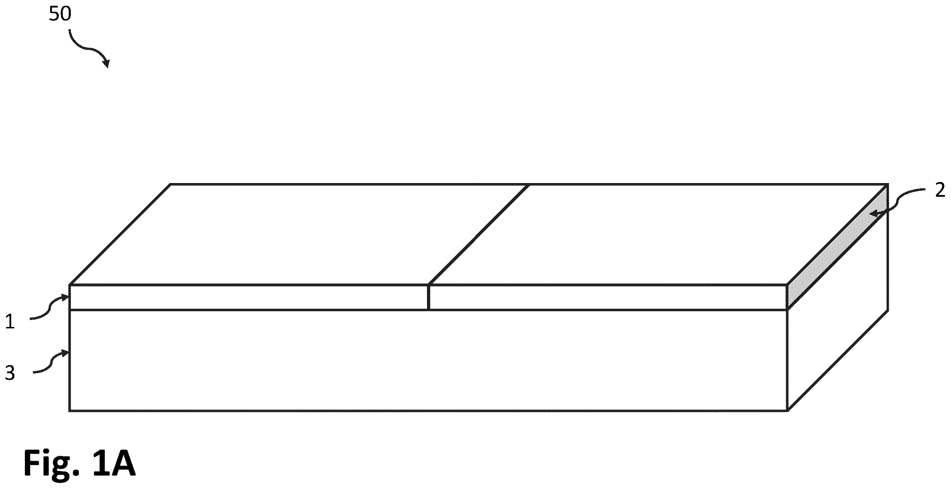

Fig. 1A shows a schematic cross-sectional view of an epiwafer 50 according to the invention. The illustration of the epiwafer 50 is purely schematic and shows the underlying substrate 3. This substrate (base-layer) 3 is preferably Si. Two surface areas are formed on this substrate. A first surface area 1 and a second surface area 2. The two surface areas differ in terms of their Ge content. The first surface area 1 has a first Ge fraction and the second surface area 2 has a second Ge fraction. The first Ge fraction is 15 % in some embodiments. The second Ge fraction is 0 % in some embodiments.

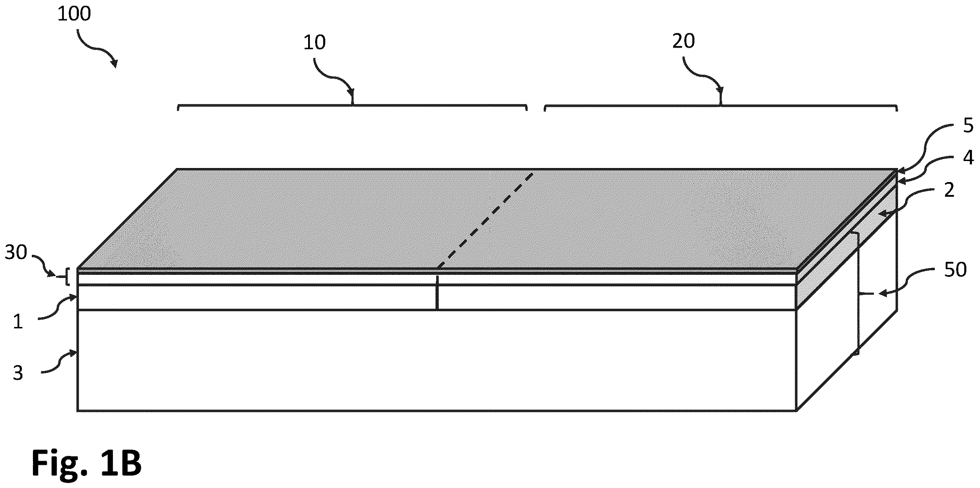

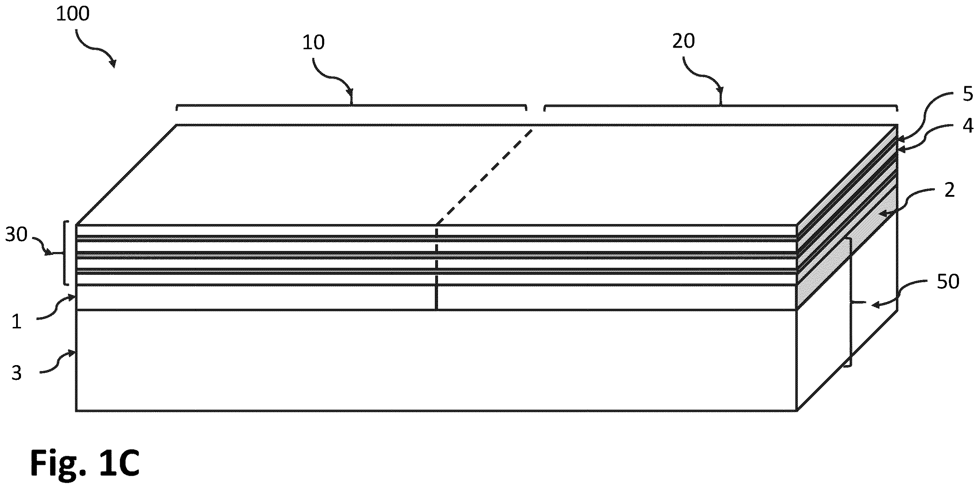

Fig. 1B shows a semiconductor device 100 comprising the epiwafer 50 of Fig. 1 and a first superlattice layer deposited on top of the two epiwafer surface areas according to the invention. For the sake of simplicity, the representation of the semiconductor structure 100 is limited to its essential functional layers, namely a substrate (base-layer) 3 with a first surface area 1 and a second surface area 2 and a first superlattice layer 30 deposited on the two surface areas on the substrate. The superlattice 30 is composed of two sectors, a first sector 10 and a second sector 20. The first sector comprises a planar superlattice whereas the second sector 20 comprises a nanodot superlattice. The figure does not show a scale view of the thickness ratios of the layers, but merely a purely schematic structural representation of a layer sequence of the active layers of the semiconductor device 100.

The superlattice 30 consists of alternating layers of a spacer-layer 4 and a confinement-layer 5. The two layers 4, 5 differ in terms of their Ge content. A spacer-layer 4 is therefore initially deposited on the first surface area 1 and the second surface area 2. After deposition of the spacer-layer 4, a confinement-layer 5 is deposited on the spacer-layer 4, forming a first layer of the superlattice 30. The spacer-layer 4 has a third Ge fraction and the confinement-layer 5 has a fourth Ge fraction. The third Ge fraction is 0 % in some embodiments. The fourth Ge fraction is 30 % in some embodiments. The thickness of the spacer-layer 4 is 50°nm in some embodiments. The thickness of the confinement-layer 5 is 5°nm in some embodiments. In some embodiments, both the spacer-layer 4 and the confinement-layer 5 are deposited under the same process conditions, i.e. by using the same growth temperatures. In some embodiments, the spacer-layer 4 and the confinement-layer 5 layers are deposited simultaneously in each sector, in that, they are formed under the same process conditions, i.e. growth temperature, precursor gas, Ge-fraction, in both the first and the second sector 10, 20.

The selection of the various Ge fractions, namely the first to fourth Ge fractions, is interdependent. Preferably, the second Ge fraction in the second surface area 2 is set within a defined range between 0 and 70 %. Based on this value, the fourth Ge fraction of the confinement-layer 5 can be determined accordingly. The fourth Ge fraction must be greater than or equal to the second Ge fraction plus 30 % (i.e., ≥ second Ge fraction + 30 %).

Depending on the chosen fourth Ge fraction, the first Ge fraction, corresponding to the first surface area 1, may be defined as a value lower by 15 to 5 % (i.e., fourth Ge fraction minus 15 to 5 %), and the third Ge fraction, which pertain to the spacer-layer 4, may be defined as a value lower by 15 to 55 % (i.e., fourth Ge fraction minus 15 to 55 %)

If either the fourth Ge fraction or the first Ge fraction is initially fixed within the specified interval, then the corresponding valid sub-ranges for the remaining fractions can be derived accordingly. By selecting the Ge fractions within these tailored ranges, it is possible to precisely control the formation or suppression of nanodots within the superlattice structure.

The dashed line in the figure is intended to indicate the first sector 10 and the second sector 20 of the superlattice, whereby the layers of the superlattice in the two sectors do not differ in their physical properties, in particular in their Ge concentrations, and are substantially formed with identical layer thickness with respect to the surface areas 2, 3 of the epiwafer 50. The figure does not show a formation of nanodots in the second sector 20.

Fig. 1C shows a schematic cross-sectional view of a semiconductor device 100 comprising the epiwafer 50 of Fig. 1 and superlattice layers deposited on top of the two epiwafer surface areas according to the invention. Figure 1C shows a semiconductor device based on the semiconductor device in Figure 1B, in which several alternating layers of the superlattice have been deposited. Figure 1C is therefore a view of the semiconductor device 100 from Figure 1B, where more superlattice layers have been deposited.

Fig. 1C also schematically demonstrates the selective formation of nanodots. In the second sector 20 (superlattice region of the second surface area 2), which has a lower Ge concentration (second Ge-fraction) in the underlying Si or SiGe layer, strain relaxation during epitaxial growth promotes the formation of nanodots (not shown here) within the confinement-layers 5 of the superlattice layers. These nanodots typically nucleate at the interfaces within the superlattice 30 as a result of local strain accumulation and energy minimization. The figure does not show a formation of nanodots in the second sector 20.

In contrast, in the first sector 10 (superlattice region of the first surface area 1), which has a higher Ge concentration (first Ge-fraction) in the underlying layer, the strain conditions are altered such that the formation of nanodots in the confinement layers 5 of the superlattice 30 is suppressed. Here, the increased Ge content leads to more homogeneous strain distribution and stabilizes the planar growth mode, thus preventing the nucleation of nanodots. Consequently, a lateral contrast in nanodot formation is achieved across both sectors of the semiconductor device.

The formation or prevention of nanodots in the superlattice 30 depends directly on the Ge concentration of the second surface area 2 in relation to the Ge concentration of the confinement-layer 5 and the associated strain distribution. In areas with lower Ge concentration in the underlying substrate surface areas (e.g. the second surface area 2), a lattice mismatch occurs during the growth of the superlattice 30 between the spacer-layer 4 and the confinement-layer 5, respectively, which leads to local strain accumulation. This strain encourages the formation of nanodots to relax the system (Stranski-Krastanov growth). In areas with a higher Ge concentration in the underlying substrate surface areas (e.g. the first surface area 1), the lattice adaptation to the overlying SiGe layers is better. This results in less strain energy and the system favours planar superlattice layer growth, which suppresses nanodot formation.

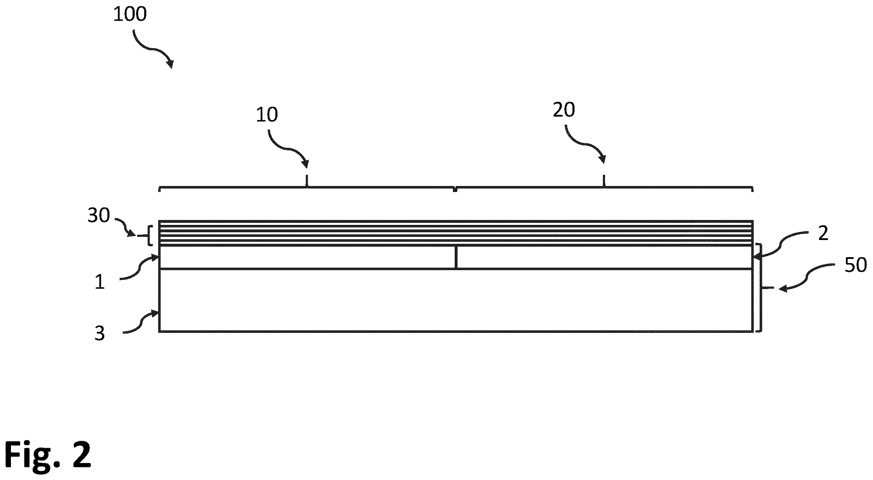

Fig. 2 shows a schematic cross-sectional view of a semiconductor device 100 comprising the epiwafer 50 of Fig. 1 and superlattice layers deposited on top of the epiwafer surface area according to the invention. The figure does not show a scale view of the thickness ratios of the layers, but merely a purely schematic structural representation of a layer sequence of the active layers of the semiconductor device 100. The figure does not show a formation of nanodots in the second sector 20.

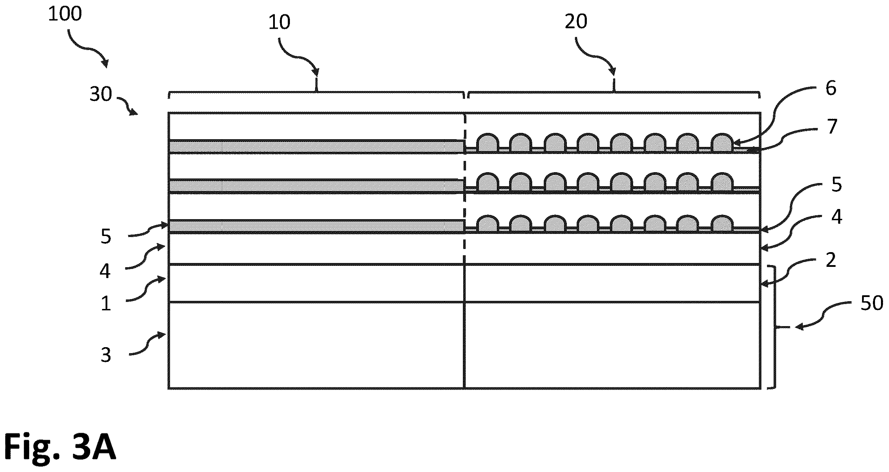

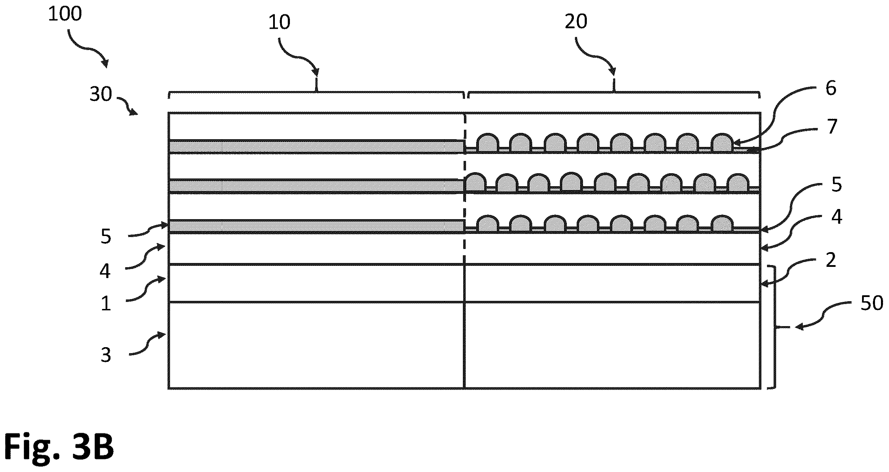

Fig. 3A and Fig. 3B show a schematic cross-sectional view of a semiconductor device 100 comprising the epiwafer 50 of Fig. 1 and superlattice layers deposited on top of the two distinct epiwafer surface areas 1, 2 with nanodots 6 formed in a superlattice sector above one of the two distinct surface areas of the epiwafer according to the invention.

Fig. 3A and Fig. 3B schematically show the presence of nanodots 6 in the second sector of the semiconductor device 100. If a superlattice 30 consisting of spacer-layer 4 and confinement-layer 5 is formed on the epiwafer 50, which has two surface areas 1, 2 with different Ge concentrations, nanodots 6 form in the confinement layer 5 in the second sector 20 of the superlattice 30. The formation of the nanodots 6 in the confinement layer 5 can be attributed to the Stranski-Krastanov mechanism.

In some embodiments, as illustrated in Fig. 3A, a lower strain difference between the substrate surface area 2 and the confinement layer 5 of the superlattice 30 results in a weaker driving force for nanodot formation. In such cases, the reduced strain energy may impede nanodot 6 nucleation, leading to planar growth instead. To counteract this and promote nanodot 6 self-assembly despite the lower strain contrast, it may be specifically beneficial to increase the growth temperature. A higher temperature enhances surface mobility and material redistribution, which can help to overcome the lower driving force and facilitate the formation of well-defined nanodots 6.

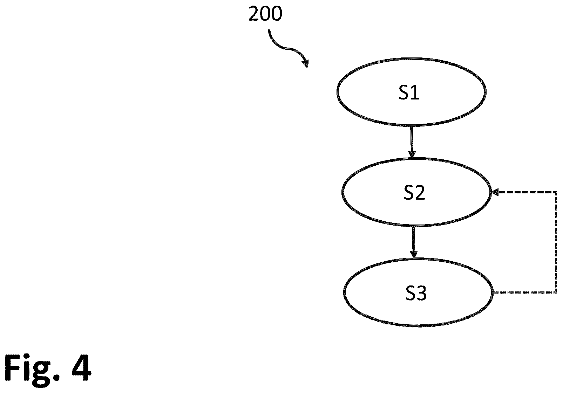

The size and the shape of the nanodots 6 of the semiconductor device 100 varies based on the used process parameters (as described under Fig. 4). The present invention is not limited to any distinct size or shape of the nanodots 6.

In some embodiments and as depicted in Fig. 3A the thickness of the confinement-layer 5 (i.e. the high-Ge layer within the superlattice 30) of the second sector 20, which comprises the nanodot superlattice, is locally reduced in the vicinity 7 of the nanodots 6. This reduction in layer thickness results from the vertical redistribution of material during nanodot formation. In contrast, in the first sector 10, which features a planar superlattice without nanodots 6, the confinement-layer 5 remains uniform in thickness. The comparison highlights how the self-assembly of nanodots in sector 20 modifies the local layer geometry, leading to a thinner confinement layer 5 around the nanodots 6 compared to the planar (flat), unstructured layer in sector 10.

In some embodiments and as depicted in Figure 3A, the local alignment of the nanodots 6 in the second sector 20 results from the epitaxial dot-on-dot growth mechanism. During the deposition of successive superlattice layers, nanodots 6 tend to nucleate preferentially above existing nanodots 6 in the underlying layers due to local strain fields. These strain fields act as energy minima, guiding the vertical positioning of newly formed nanodots 6. As a result, a three-dimensional (3D) ordered structure is established, where nanodots 6 align vertically across multiple confinement-layers 5. This 3D ordered alignment enables carrier transportation control, making such structures suitable for quantum devices and optoelectronic applications.

Fig. 3B schematically shows the presence of nanodots 6 in the second sector of the semiconductor device 100. The semiconductor device 100 is designed like the semiconductor device 100 described under Fig. 3A. The only difference is that, unlike the dot-on-dot alignment in Fig. 3A, the nanodots in Fig. 3B are arranged in a staggered alignment. In staggered alignment, nanodots are arranged laterally displaced in different layers. This means that nanodots in an upper layer are shifted laterally relative to the nanodots below them. This displacement prevents direct superposition. Such an arrangement can lead to different electronic or optical properties, as the coupling between the layers is different.

Fig. 4 shows a schematic representation of the process steps 200 to manufacture a semiconductor device 100 according to the invention.

In a first step S1 a base-layer 3 of the epiwafer 50 is provided. The base-layer 3 can be made of Si.

In a next step S2, the base-layer 3 of the epiwafer 50 is structured with at least one first surface area 1 made of SiGe with a first Ge fraction and at least one second surface area 2 made of Si or SiGe with a second Ge fraction. The epiwafer 50 may be fabricated by selective epitaxial growth (SEG) or lithographic patterning combined with etching and regrowth techniques, followed by planarization techniques e.g. chemical mechanical polishing (CMP). In one embodiment, a uniform Si substrate (base-layer 3) is first prepared, followed by localized deposition of SiGe to form the first surface area 1. This can be achieved using selective-area chemical vapor deposition (CVD), where SiGe is deposited only in predefined regions, often defined by a dielectric mask. The second surface area 2 remains either undeposited (retaining pure Si) or is formed with a different Ge content by a separate epitaxial step. The thickness of the surface areas (doped regions within the substrate) may be over 500°nm. The Ge-fractions are selected as described above under Figure 1B. At the end of step S2 the epiwafer 50 is formed comprising a substrate base-layer and two surface areas with different Ge concentrations.

In a further step S3 a differential epitaxial deposition on the first surface area 1 and second surface area 2 is performed, comprising depositing a periodic layer sequence of a spacer-layer 4 made of Si or SiGe with a third Ge fraction or C-doped with a C fraction and a confinement-layer 5 made of SiGe with a fourth Ge fraction.

In Step S3, a superlattice-layer is deposited onto the previously prepared epiwafer 50, which comprises laterally distinct surface areas (first surface area 1 and second surface area 2). The deposition of the superlattice-layer is carried out by epitaxial growth, preferably using chemical vapor deposition (CVD) techniques such as reduced pressure CVD (RPCVD) or ultra-high vacuum CVD (UHVCVD).

In the illustrated embodiments corresponding to Figures 1B to 3, the superlattice growth starts with the deposition of a (initial) spacer-layer 4 on both the first substrate surface area 1 and second substrate surface area 2. This (initial) spacer-layer is typically composed of Si or low-Ge SiGe or C-doped Si, and serves to spatially separate the substrate from the active nanostructure region, reducing direct interaction and minimizing interface defects.

Following the (initial) spacer-layer, the superlattice-layer is formed by the deposition of the confinement-layer 5 on top of the (initial) spacer-layer. The confinement-layer 5 is a high-Ge SiGe layer, which enables strain accumulation and, in regions with suitable substrate composition, can promote the self-assembly of nanodots.

In some embodiments, the growth of the superlattice may start with an (initial) confinement-layer followed by a spacer-layer 4. In other words, in some embodiments the first layer of the superlattice (adjacent to the surface areas 1, 2) can be selected from both the spacer-layer 4 and the confinement-layer 5.

The step S3 can be executed several times (dashed line in Fig. 4) to obtain a semiconductor device with a desired number of superlattice layers 30. Following the first superlattice-layer, the subsequent superlattice-layers are formed by the alternating deposition of confinement-layers 5 and spacer- layers 4. The spacer-layers 4 between confinement-layers 5 act as strain-compensating layers, often composed of Si or low-Ge SiGe or C-doped Si, and control the vertical spacing of nanodots, enabling dot-on-dot alignment as seen in the second sector 20 (Fig. 3).

In some embodiments, the end of the superlattice 30 (the last deposited superlattice-layer) can be selected from both the spacer-layer 4 and the confinement-layer 5.

In some embodiments the superlattice is composed of several numbers of an alternating layer sequence, preferably of 10 layer sequences.

The composition and thickness of each layer are carefully tuned during growth, with parameters such as growth rate, temperature, and gas precursor ratios being controlled to ensure layer uniformity and desired strain profiles. This controlled superlattice 30 deposition enables the selective formation of nanodots in one region (second surface area) and suppression of dot formation in the other (first surface area), as dictated by the underlying Ge concentration and local strain energy.

The thickness of the spacer-layer 4 and the confinement-layer 5 may be varied between 10 to 60 nm and 1.5 to 15 nm respectively. The Ge-fractions are selected as described above under Figure 1B.

The size of the nanodots 6 depends on the strain and the growth conditions, such as the growth temperature, the Ge-fraction used and the amount of material used. In some embodiments, the temperature is 550°C during both the growth of the spacer-layer 4 and the confinement-layer 5. In some embodiments, the growth temperature is 550°C during formation of the confinement-layer 5 and increases up to 700°C during formation of the spacer-layer 4.

To summarize, the semiconductor device may be obtained in the following way:
- The substrate is pre-patterned into two surface areas: First surface area 1: i.e. SiGe (first Ge fraction) surface (lower strain due to reduced lattice mismatch); Second surface area 2: SiGe or pure Si surface (higher compressive strain in deposited SiGe layers).
- Identical Si/SiGe superlattice layers are deposited across both sectors in one process (comprising of spacer-layer 4 and confinement-layer 5).

First sector 10 (on SiGe surface area with first Ge fraction): Reduced lattice mismatch lowers strain energy, suppressing nanodot nucleation and resulting in planar superlattices.
Second sector 20 (on Si or SiGe surface area with second Ge fraction): Higher compressive strain in SiGe confinement-layers exceeds the critical threshold for Stranski-Krastanov transition, inducing nanodot formation.
Spacer-layer 4: Si or low-Ge SiGe (third Ge fraction, e.g., < 15 %) or C-doped Si (C fraction e.g., <5%) to maintain epitaxial coherence.
Confinement layer 5: High-Ge SiGe (fourth Ge fraction, e.g., ≥ 30 %) to induce strain-driven self-assembly on Si sectors.

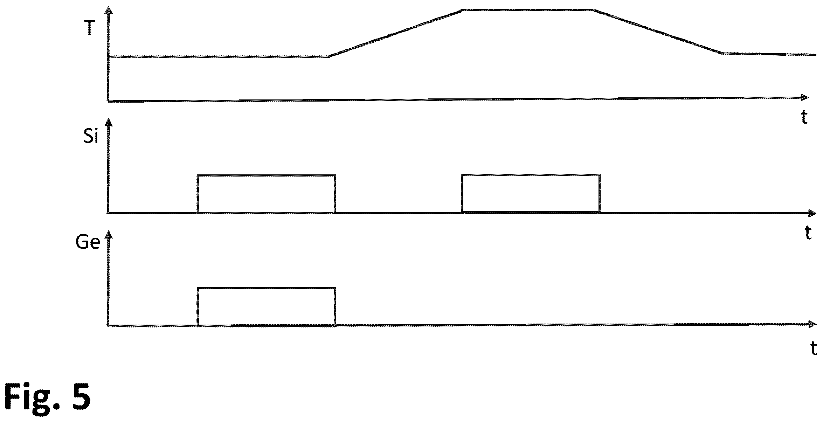

Fig. 5 shows a schematic representation of the deposition process of Si or SiGe or C-doped Si to form the superlattice layer 30 of the semiconductor device 100 according to an embodiment of the invention. The figure shows three graphs. The first graph (counted from the top) shows the growth temperature over the process time. The second graph shows the silane (SiH₄) gas flow for depositing Si over the process time. The third graph shows the germane (GeH₄) gas flow for depositing Ge over the process time.

In some embodiments, and as illustrated in Fig. 5, the deposition of Si and SiGe layers is carried out using hydrogen (H₂) as the carrier gas in a chemical vapor deposition (CVD) process. Silicon (Si) is deposited using silane (SiH₄) as the precursor gas, while germanium (Ge) is deposited using germane (GeH₄). For the growth of mixed SiGe layers, such as the confinement layer 5, which typically exhibits a high Ge content, both gas flows (SiH₄ and GeH₄) are simultaneously introduced into the reaction chamber. The Ge fraction in the resulting SiGe layer is precisely controlled by adjusting the relative flow rates of SiH₄ and GeH₄. Likewise, the layer thickness is controlled by the deposition time and the total gas flow rate. This enables the formation of SiGe layers with defined composition and thickness, which are critical for achieving the desired strain and electronic properties in the superlattice structure.

In some embodiments, the temperature is 550°C during both the growth of the spacer-layer 4 and the confinement-layer 5. In some embodiments, the growth temperature is 550°C during formation of the confinement-layer 5 and increases up to 700°C during formation of the spacer-layer 4.

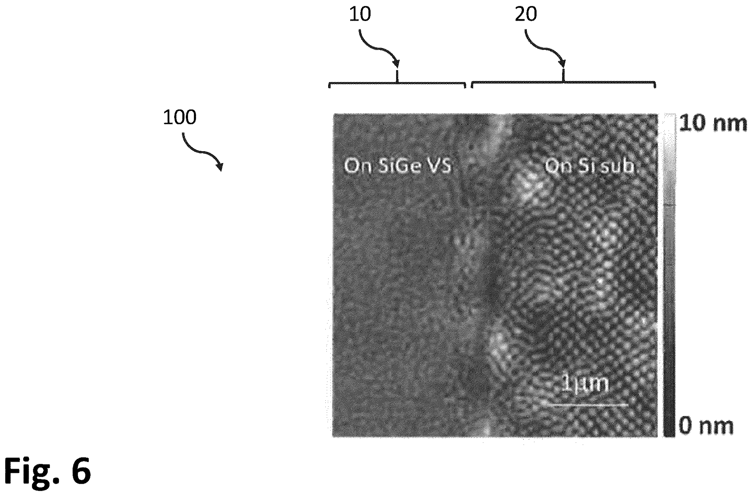

Fig. 6 shows a schematic representation of the surface structure (topography) of the superlattice between the two sectors 10, 20 above the two distinct surface areas 1, 2 of the underlying epiwafer (AFM-measurement) according to an embodiment of the invention.

Fig. 6 shows an atomic force microscopy (AFM) image of a 10-cycle superlattice consisting of 10 alternating layers of confinement-layers 5 with a Ge-fraction of 15 % and a layer thickness of 5 nm and spacer-layers 4 with a Ge-fraction of 0 % and a layer thickness of Si 50 nm, deposited on a patterned Si epiwafer. The base-layer 3 of the substrate is Si. The underlying substrate features locally defined surface areas with a 15 % Ge-fraction in the first surface area, enabling site-specific strain conditions. The growth temperature is 550°C during formation of the confinement-layer 5 and 700°C during formation of the spacer-layer 4. The AFM image reveals the resulting surface morphology, where the local Ge concentration influences the formation or suppression of nanodots within the superlattice 30. The image demonstrates the feasibility of lateral nanostructure control via substrate patterning and composition engineering.

The surface topography (AFM-image) of the semiconductor device according to Fig. 6 was obtained using the following values for the different surface areas / sectors.

| | Ge concentration | | Nominal thickness |
|---|---|---|---|
| | second sector / second surface area | first sector / first surface area | |
| confinement-layer (Y) | Y = 30 % | | 5 nm |
| spacer-layer (Z) | Z = 0 % | | 50 nm |
| substrate (X / W) | X = 0 % | W = 15 % | |

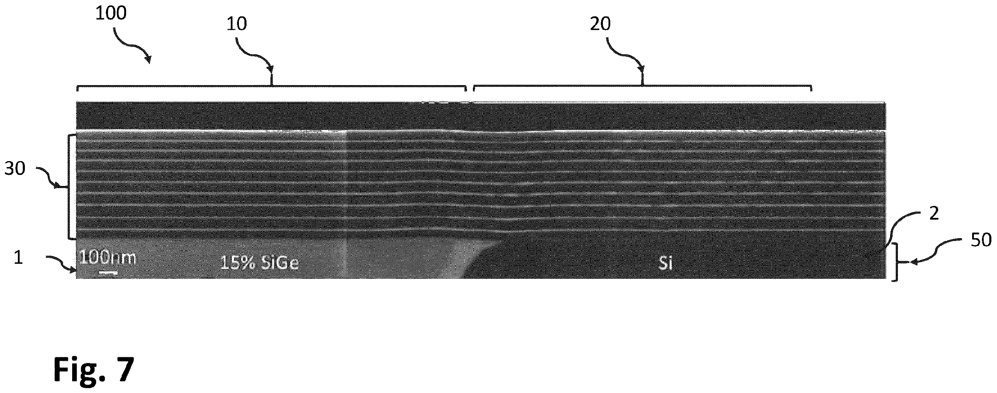

Fig. 7 shows a schematic cross-sectional view of a superlattice 30 deposited to the epiwafer 50 comprising two distinct surface areas 1, 2 according to an embodiment of the invention.

Figure 7 is a cross-section of the surface image of Fig. 6. In these figures there are no nanodots visible due to their smaller scale compared to the SEM-image ratio. The structured substrate, i.e. the epiwafer 50, consists of two surface areas with different Ge-fractions.

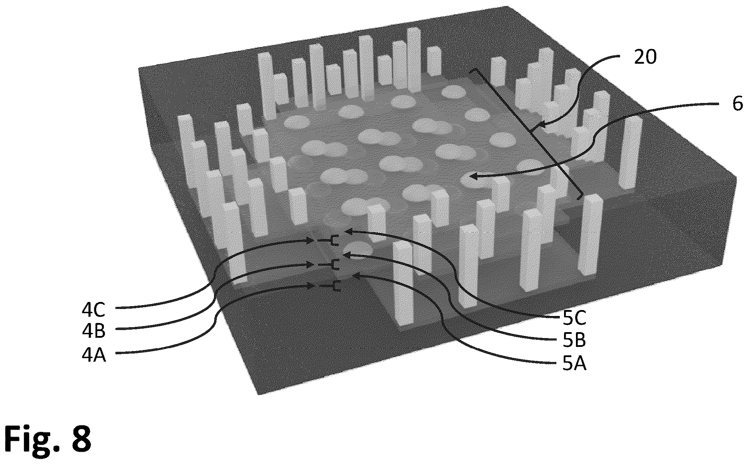

Fig. 8 shows a schematic concept of the 3D staggered aligned SiGe semiconductor device 100 according to an embodiment of the invention.

The local 3D-aligned SiGe nanodot superlattice formation and planar superlattice formation can be applied for new quantum computing with new device design concept. The SiGe planar superlattice sector can be used for electric contact for individual layers and the 3D-aligned SiGe nanodot superlattice sector part can be used for carrier confinement as shown in Fig. 8.

Fig. 8 shows three superimposed layers of spacer-layer 4A-4C and confinement-layer 5A-5C. The spacer-layers 4A-4C and confinement-layers 5A-5C can be contacted. The contacts are represented in figure 8 by rectangular bars that contact each of the three layers of the spacer-layers 4A-4C or confinement-layers 5A-5C. Nanodots 6 form in the nanodot superlattice (second sector 20).

## Claims

1. A semiconductor device comprising:
- an epiwafer (50) comprising
- a substrate (3) with,
at least one first laterally defined surface area (1) made of SiGe with a first Ge fraction and,
at least one second laterally defined surface area (2) made of Si or SiGe with a second Ge fraction smaller than the first Ge fraction,
- at least one first sector (10) comprising a planar superlattice deposited on the first surface area,
- at least one second sector (20) comprising a nanodot-superlattice deposited on the second surface area, wherein
- the planar superlattice and the nanodot-superlattice are made of a differentially deposited periodic layer sequence of a spacer-layer (4) made of Si or SiGe with a third Ge fraction or C doped Si with a C fraction and a confinement-layer (5) made of Ge or SiGe with a fourth Ge fraction higher than the third Ge fraction, wherein
- due to a selected first value of the first Ge fraction in the first surface area (1) and a first local strain amount in the confinement-layer (5), the confinement-layer (5) of the planar superlattice is planar, that is, without any nanodot formation, and wherein
- due to a selected second value of the second Ge fraction in the second surface area (2) and a second local strain amount in the confinement-layer (5), the confinement-layer (5) of the nanodot-superlattice comprises Ge or SiGe nanodots.

2. The semiconductor device according to claim 1, wherein the first Ge fraction of the first surface area (1) is 5 to 15% lower than the fourth Ge fraction of the confinement-layer (5)

3. The semiconductor device according to claim 1 or 2, wherein the second Ge fraction of the second surface area (2) lies within a range between 0 to 70 %.

4. The semiconductor device according to any of the preceding claims, wherein the fourth Ge fraction of the confinement-layer (5) of the first sector (10) and second sector (20) is at least 30 % larger than the second Ge fraction of the second surface area (2).

5. The semiconductor device according to any of the preceding claims, wherein the third Ge fraction of the spacer-layer (4) of the first sector (10) and second sector (20) is 15 to 55% lower than the fourth Ge fraction of the confinement-layer (5).

6. The semiconductor device according to any of the preceding claims, wherein the C fraction of the C doped Si spacer-layer is below 5°%.

7. The semiconductor device according to any of the preceding claims, wherein any internal interfaces between a respective pair of confinement-layer (5) and an adjacent spacer-layer (4) in the nanodot-superlattice of the second sector (20) and the planar superlattice of the first sector (10) are at a respective substantially identical distance above the first surface area (1) and second surface area (2) of the epiwafer (50) in a stacking direction of the superlattice (30).

8. The semiconductor device according to any of the preceding claims, wherein the Ge or SiGe nanodots (6) of the second sector (20) are mutually aligned in a stacking direction of the superlattice (30) and in a lateral direction perpendicular to the stacking direction.

9. The semiconductor device according to any of the preceding claims, wherein the thickness of the spacer-layer (4) lies in a range between 10 nm to 60 nm.

10. The semiconductor device according to any of the preceding claims, wherein the thickness of the confinement-layer (5) lies in a range between 1.5 nm to 15 nm.

11. A method of manufacturing a semiconductor device comprising the steps of:
- providing an epiwafer (50) comprising a substrate (3) with at least one first laterally defined surface area (1) made of SiGe with a first Ge fraction and at least one second laterally defined surface area (2) different from the first surface area and made of Si or SiGe with a second Ge fraction, wherein the second Ge fraction is smaller than the first Ge fraction,
- performing a differential epitaxial deposition on the first and second surface areas (1, 2), comprising depositing a planar superlattice on the first surface area (1) and depositing a nanodot-superlattice on the second surface area (2), wherein
- the planar superlattice and the nanodot-superlattice are made of a periodic layer sequence of a spacer-layer (4) made of Si or SiGe with a third Ge fraction or C doped Si with a C fraction and a confinement-layer (5) made of Ge or SiGe with a fourth Ge fraction higher than the third Ge fraction, wherein
- the first Ge fraction in the first surface area (1) and the fourth Ge fraction in the confinement-layer (5) are selected to achieve a first local strain amount in the confinement-layer (5) to effect growth of the confinement-layer (5) of the planar superlattice as a planar layer, that is, without any nanodot formation, and wherein
- the second Ge fraction in the second surface area (2) and the fourth Ge fraction in the confinement layer (5) are further selected to achieve a second local strain amount in the confinement-layer (5) to effect growth of the confinement-layer (5) of the nanodot-superlattice in the form of Ge or SiGe nanodots (6).

12. The method according to claim 11, comprising the step of:
- forming Ge or SiGe nanodots (6) using the Stranski-Krastanov growth mechanism.

13. The method according to claim 11 or 12, wherein differentially depositing comprises simultaneously depositing each nanodot-superlattice layer and each corresponding planar-superlattice layer using identical settings of a growth reactor used for performing the method, including an identical precursor gas flow setting and an identical growth temperature setting.

14. The method according to any of claims 11 to 13, comprising the steps of:
- setting a first growth temperature for depositing Ge or SiGe to form the confinement-layer (5) of the nanodot-superlattice and the planar superlattice,
- setting a second growth temperature for depositing Si or SiGe or C doped Si to form the spacer-layer (4) of the nanodot-superlattice and the planar superlattice,
wherein the second growth temperature is higher than or equal than the first growth temperature.

15. The method according to claim 14, wherein the first growth temperature is increased up to the second growth temperature after the deposition of the confinement-layer (5) and before the deposition of the spacer-layer (4).
